# EUROPEAN PATENT APPLICATION

(11) **EP 1 203 962 A2**
(43) Date of publication of application: **08.05.2002**
(21) Application number: 01309331.5
(22) Date of filing: 02.11.2001
(51) Int. Cl.: G01R 31/28

(54) **A test instrument powered video camera**

(30) Priority: 03.11.2000 US 706144
(71) Applicant: Tektronix, Inc., Beaverton, OR 97077-0001 (US)
(72) Inventor: Tallman, James L., Beaverton, Oregon 97007 (US); Kawabata, Frederick Y., Beaverton, Oregon 97006 (US); Climer, Eugene J., Beaverton, Oregon 97007 (US); Nightingale, Mark W., Washougal, Washington 98671 (US)
(74) Representative: Burke, Steven David

(57) **Abstract**

A test system includes a test instrument with an input terminal for receiving a test signal, and a power output terminal for supplying electrical power. The test instrument is capable of receiving a video signal at the input terminal and displaying the image represented by that video signal. A camera, receives operating power from the power output terminal of the test instrument, and has an output terminal, generating a video signal, coupled to the input terminal of the test instrument.

## Description

### FIELD OF THE INVENTION

The present invention relates to a video camera designed for use with an electronic test instrument, such as an oscilloscope.

### BACKGROUND OF THE INVENTION

Oscilloscopes have long been able to display signal waveforms, including video signal waveforms. Oscilloscopes also have recently been designed to display not only the video signal waveform, but also the image represented by that video signal. In this way, it may be easily verified that the video signal waveform being displayed is from the desired video signal source.

Some oscilloscope probes require circuitry at the end of the probe connected to the unit-under-test to accurately acquire the test signal, and that circuitry requires power to operate properly. Such probes are supplied with power from the oscilloscope itself. This arrangement is known as probe powered.

In addition, as electronic circuitry gets smaller and smaller, it is often necessary for test probes on e.g. oscilloscopes to connect to physically small circuit details. This often requires special equipment to enable a user to see such small details, and/or requires robotic positioning.

### BRIEF SUMMARY OF THE INVENTION

The inventors have realized that video cameras have been miniaturized to the point where they take up about the same amount of space as an oscilloscope probe. Video cameras further require only a relatively low operating voltage, on the order of from 5 volts to 20 volts. The inventors also realized that the same power from the oscilloscope which provides power to oscilloscope probes can provide power to the camera.

In accordance with principles of the present invention, a test system includes a test instrument with a channel having an input terminal for receiving a test signal, and a power output terminal for supplying electrical power. The test instrument is capable of receiving a video signal at the input terminal and displaying the image represented by that video signal. A camera, receives operating power from the power output terminal of the test instrument, and has an output terminal, generating a video signal, coupled to the input terminal of the test instrument.

### BRIEF DESCRIPTION OF THE DRAWING

In the drawing:
Fig. 1 is a diagram illustrating the use of a scope powered camera according to principles of the present invention with an oscilloscope;
Fig. 2 is a more detailed block diagram of a portion of the circuitry illustrated in Fig. 1;
Fig. 3 is a diagram illustrating an assembly for using a probe powered camera and oscilloscope probe according to principles of the present invention;
Fig. 4 is a block diagram of a probe powered camera also including a light source;
Fig. 5 is a diagram illustrating an alternative assembly for minimizing shadows resulting from an assembly of a light source and a camera, as illustrated in Fig.4;
Fig. 6 is a diagram illustrating an assembly for using a probe powered camera and oscilloscope probe also including a light source and diffuser;
Fig. 7 is a diagram illustrating an arrangement in which the camera is relatively fixed; and
Fig. 8 is a side view of an arrangement in which the probe is moveable relative to the camera.

### DETAILED DESCRIPTION OF THE INVENTION

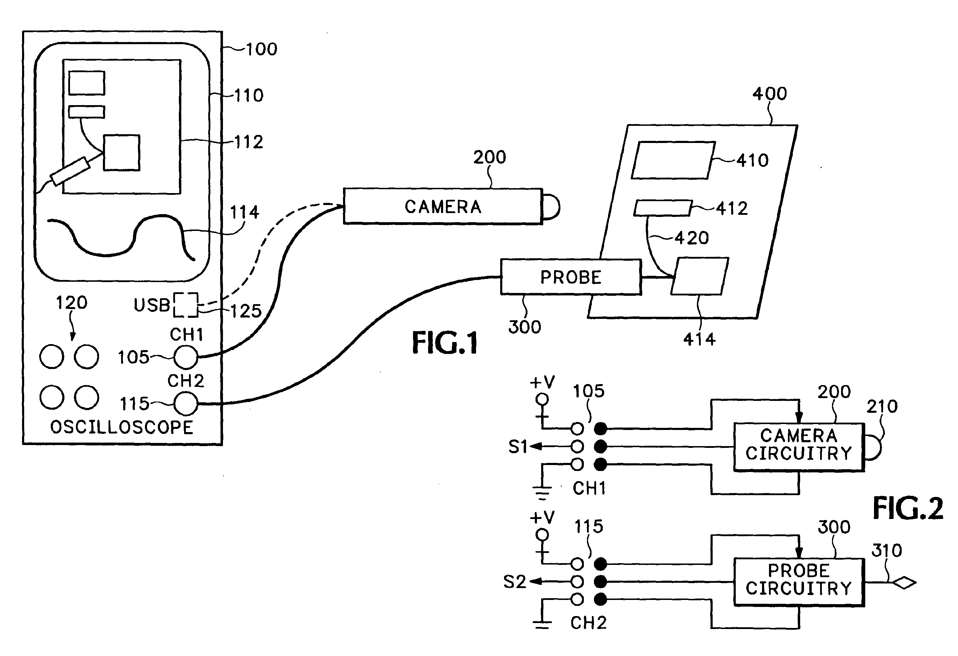

In the figures, those elements which are the same from figure to figure will be designated by the same reference number and will not be described in detail after the initial description. Fig. 1 is a diagram illustrating the use of a scope powered camera, according to principles of the present invention, with an oscilloscope. In Fig. 1, an oscilloscope 100 is a digital storage oscilloscope (DSO) which includes a first input port 105, termed a channel (CH1), coupled to a camera 200, and a second input port 115 (CH2) coupled to a probe 300. In Fig. 1, the probe 300 is illustrated as connected to an electronic circuit board (ECB) 400. The ECB 400 is illustrated as containing circuit elements 410, 412 and 414, and an interconnection 420 running between an electrode of circuit element 412 and an electrode of circuit element 414. One skilled in the art will understand that many more circuit elements and interconnections than those illustrated in FIG. 1 may be contained on such an ECB. The oscilloscope 100 includes a display device 110 on which waveform traces, and images represented by video signals may be displayed. The oscilloscope 100 also includes controls and displays 120, which can include dials, switches, buttons and lights arranged in a known manner.

In operation, the user of the oscilloscope 100 operates the controls and displays 120, to properly configure the operation of the oscilloscope 100 and to help interpret the waveform traces displayed on the display device 110. In general, the oscilloscope 100 samples the signal at the channel input terminal CH2, representing the signal received by the probe 300 from the interconnection 420, then processes the samples to generate a waveform display 114 on the display device 110, all in a known manner. Simultaneously, the camera 200 receives power from the oscilloscope 100. The camera 200 is focused on the scene of the ECB 400. The video signal generated by this camera is supplied to the CH1 input port. The oscilloscope 100 is conditioned, using the controls and displays 120, to sample the video signal and process those samples, not to generate a waveform of that signal, but instead to display the image 112 seen by the camera 200 on the display device 110. This embodiment maybe used in DSOs such as the TDS 3000 family of oscilloscopes manufactured by Tektronix, Inc.

In an alternative embodiment, the oscilloscope 100 is fabricated as a computer system which can run e.g. the Microsoft Windows operating system using the display device 110 as a monitor, such as the TDS 7000 family of oscilloscopes manufactured by Tektronix, Inc. In such oscilloscopes, standard computer data input and output terminais may be used in addition to the channel input terminals (CH1, CH2) present in the oscilloscope 100. In the illustrated alternative embodiment, the camera 200 is connected to the oscilloscope 100 via a USB port 125. This is shown in phantom in Fig.1. One skilled in the art will understand that any type of computer data input terminal may be included in the oscilloscope 100 and used for receiving the video signal, such as a firewire, serial, or parallel port, provided it can receive data from the camera 200 without losing data, and provide a source of operating power to the camera 200.

In the operation of the alternative embodiment, the signal from the channel input terminal CH2 is digitized and processed to generate the waveform image 114 and the waveform image 114 is displayed on the display device 110, in the manner described above, all under control of a Windows program. Simultaneously, the digitized video signal from the camera 200 is received from the USB port and digitized in a known manner. In one embodiment, a window (not shown) is created on the display device 110 in which the image represented by that video signal is displayed under control of a commercially available Windows program. This window, however, may overlay the waveform 114 display window. Thus, in a preferred embodiment, the image 112 represented by the video signal is integrated with the waveform image 114 generated in the manner described above, as illustrated in Fig. 1.

In a similar manner to the operation of the channel ports 105 and 115, the USB port provides a source of operating power for circuitry connected to it, and can receive data from such circuitry, all in a known manner. The USB port, however, is a digital port. Therefore, in this embodiment, the camera 200 includes known video capture circuitry for encoding the image representative signal into digital form. However, whether the image representative signal from the camera is provided directly to the channel 1 input port 105, or to the USB input port 125, the operation of the oscilloscope 100 to display the image represented by that signal is the same.

Fig. 2 is a more detailed block diagram of a portion of the circuitry illustrated in Fig. 1. In Fig. 2, each channel (CH1, CH2) includes a connection (105,115) for three signal lines. In each connector, one signal line is connected to a source of reference potential, or ground. A second signal line is connected to a source of operating potential +V. A third signal line carries the input signal S, and is connected to input circuitry in the oscilloscope 100 for displaying the waveform on that signal, or the image represented by the signal if it is a video signal. One skilled in the art will understand that additional signal lines may carry more than one operating voltage. For example, current oscilloscopes produce operating voltages such as +18, -18, +15, -15, +12, -12 and +5 volts, or the like.

Referring to CH2 115, the operating voltage source +V is connected to a power input terminal of input circuitry in the probe 300. Similarly, the ground terminal is coupled to a ground terminal of the probe circuitry 300. The input connector 310, which is capable of connecting to circuit nodes on the ECB 400, is connected to a signal input terminal of the probe circuitry 300. An output terminal of the probe circuitry 300 generates the test signal S2 for CH2, and is coupled through the connector 115 to processing circuitry (not shown) in the oscilloscope 100 for displaying the waveform (114 of Fig. 1) of the test signal S2, all in a known manner.

Similarly, in CH1 105, the operating voltage source +V is connected to a power input terminal of the camera 200 and the ground terminal is coupled to a ground terminal of the camera 200. A lens 210 receives an optical image, and focuses it on an image receiving device (not shown) within the camera 200. An output terminal of the camera 200 generates a video signal S 1, representing the image seen by the lens 210, for CH1, and is coupled through the connector 105 to processing circuitry (not shown) in the oscilloscope 100. The oscilloscope 100 is conditioned to display the image (112 of Fig. 1) represented by the video signal S1.

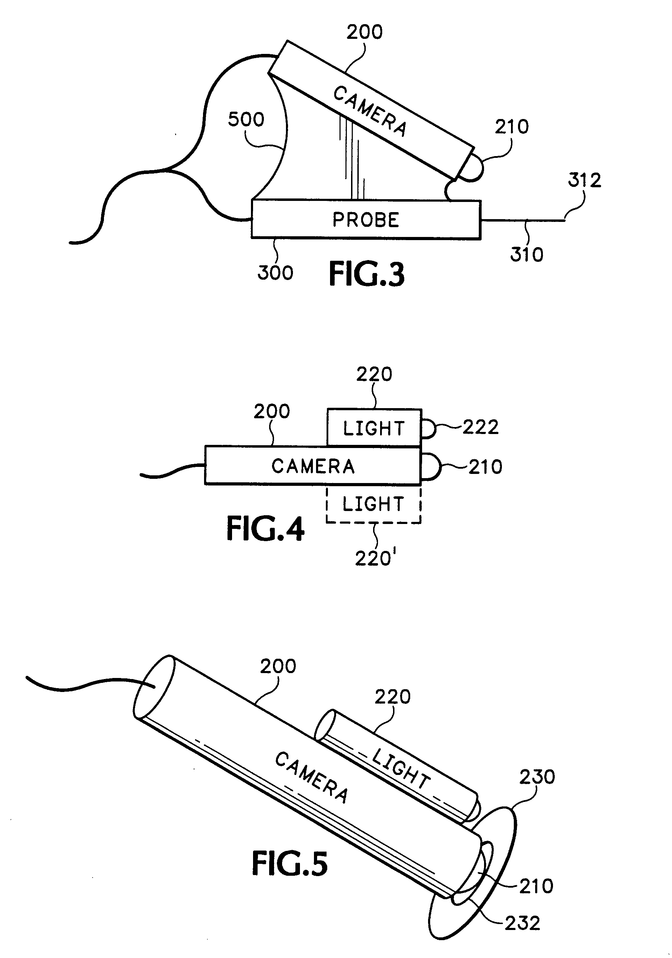

Fig. 3 is a diagram illustrating an assembly for using a probe powered camera 200 and oscilloscope probe 300 according to principles of the present invention. In Fig. 3, the probe powered camera 200 is physically connected to the oscilloscope probe 300 by a holder 500. The camera 200 and probe 300 are arranged in such a manner that the tip 312 of the connector 310 of the probe 300 is in the center of the image formed by the camera 200, and at the focal point of the lens 210. The holder 500 may be fabricated in any manner and shape, and of any appropriate material, that will hold the camera 200 and probe 300 in the required positions to enable the tip 312 of the connector 310 of the probe to be maintained in position on the desired circuit node on the ECB 400, and in focus at the center of the image formed by the camera, as described above.

As described above, the image 112 from the camera is displayed on the display device 110 of the oscilloscope 100. The assembly of camera and probe, illustrated in Fig. 3, may be physically manipulated by the user, while the user is watching the video image 112 on the display device 110 of the oscilloscope 100. The manipulation of this assembly may be by hand, or by control of a robotic device on which the assembly is mounted. The assembly is manipulated until the tip 312 of the probe 300 is at the desired circuit node on the ECB 400. The waveform trace 114 of the signal on that circuit node may then be observed on the display device of the oscilloscope.

There is sometimes insufficient light for the camera 200 to form an image of sufficient quality to be of use in manipulating the oscilloscope probe 300. Fig. 4 is a block diagram of a probe powered camera 200 also including a light source. In Fig. 4, a light source 220 is physically attached to the camera 200. The light source 220 receives power from the oscilloscope in the same manner as the camera 200 does. The light source may also include a lens 222 for focusing the light from the light source 220 at the focal point of the lens 210 of the camera 200.

In operation, the light 220 may be turned on whenever the camera 200 is in operation, or may be separately controllable. When there is insufficient ambient light to generate a useable image 112, the light 220 will produce enough light *in situ* to allow the camera to operate.

One skilled in the art will observe that a single light source will produce a shadow of the connector portion 310 of the oscilloscope probe 300, and possible other portions of the assembly of camera 200 and probe 300. This may be eliminated by including a second light source, illustrated in Fig. 4 as 220'. As with light source 220, the second light source 220' receives power from the oscilloscope, and may include a lens which focuses the light at the focal point of the lens 210 of the camera 200.

Fig. 5 is a diagram illustrating an alternative assembly for minimizing shadows resulting from an assembly of a light source and a camera, as illustrated in Fig. 4. In Fig. 5, a single light source 220 is attached to the camera 200. A light diffuser 230, of known design, is placed in front of the light source 220. The light diffuser 230 diffuses the light from the light source 220 over a wider area, thus minimizing shadows which are caused by a single light source 220. More specifically, the diffuser illustrated in Fig. 5 is substantially annular shaped, having an opening 232 in the center through which the lens 210 of the camera 200 may focus. In Fig. 5, the light from the light source 220 is diffused by the diffuser so that it is emitted by the surface of the diffuser 230, on all sides of the focal point of the lens 210. Because the light comes from all sides of the focal point of the lens 210, no shadows are cast.

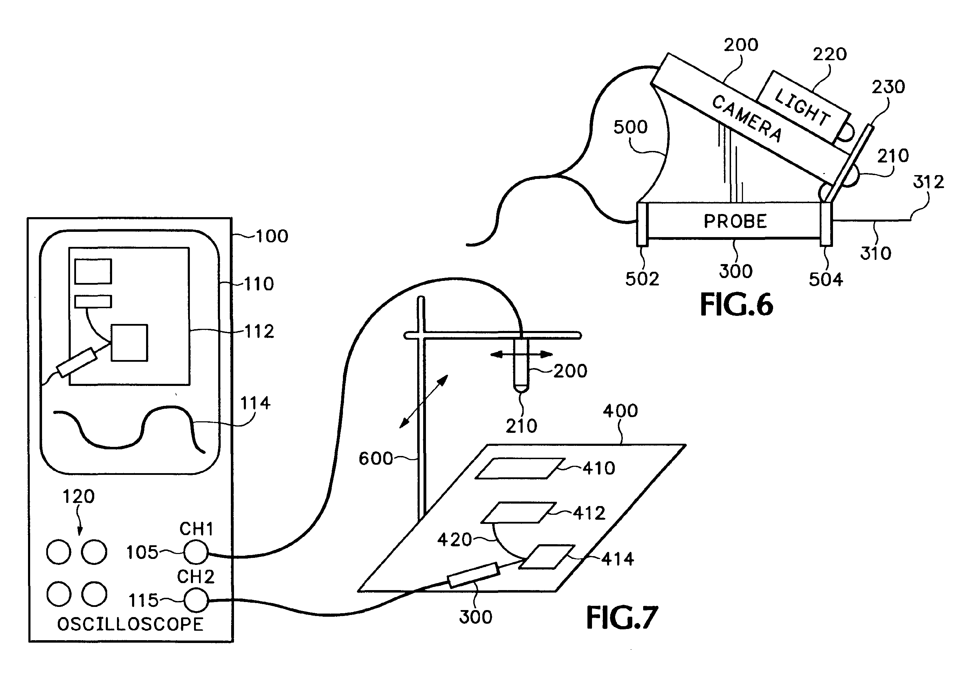

Fig. 6 corresponds to Fig. 3, and is a diagram illustrating an assembly for using a probe powered camera and oscilloscope probe also including a light source and diffuser. In Fig. 6 an assembly of a camera 200 and probe 300 are arranged so the tip 312 of the connector 310 of the probe 300 is in the center of the image formed by the camera 200, and in focus. A light source 220 and diffuser 230 are also a part of the assembly and are arranged to generate light around the location of the tip 312 of the connector 310 of the probe 300. The diffuser 230 is positioned so that no shadows are produced by the connector 310 of the probe 300, as described above.

In Fig. 6, the holder 500 also includes probe grips 502 and 504. The probe grips 502 and 504 are a part of the holder 500, and are arranged to grip a probe 300 in the appropriate position to maintain the tip 312 of the connector 310 of the probe 300 in focus at the center of the image formed by the camera, as described above. The probe grips 502 and 504 further allow the probe 300 to be removed and replaced with another probe 300. This permits the use of different probes, possibly with different circuitry, having different functions, with the camera 200. As described above, the holder 500, with the probe grips 502 and 504 may be fabricated of any material capable of allowing the probe 300 to be removed and replaced, and, as described above, of holding the probe 300 and camera 200 in the appropriate positions.

The inventors have also found that it is sometimes easier to hold the camera 200 substantially fixed with respect to the target (i.e. the ECB 400 in Fig. 1 and move the probe with respect to both the target 400 and camera 200. Fig. 7, corresponding to Fig. 1, is a diagram illustrating an arrangement in which the camera 200 is maintained substantially fixed with respect to the ECB 400. In Fig. 7, the camera 200 is attached to a stand 600. The stand 600 is arranged so that the camera 200 is held over, and substantially fixed with respect to the ECB 400. The camera 200 is pointed in the direction of the ECB 400. The lens 210 forms an image of the ECB 400. The image 112 is displayed on the display device 110 of the oscilloscope 100. The probe 300 is moved by a user to the desired position, on connector 420 near circuit element 414, by looking at the image 112. The image of the probe is shown in the displayed image 112. By holding the camera 200 relatively fixed relative to the target ECB 400, the probe 300 may be more easily maneuvered in some cases.

In the arrangement illustrated in Fig. 7, the lens 210 in the camera 200 may be selected so that the entire ECB 400 is within the image, as illustrated in the image 112 of Fig. 7. Alternatively, the lens 210 may be selected so that only a portion of the ECB 400 is displayed, effectively magnifying the ECB 400 image 112 on the oscilloscope 112. Such a lens will allow accurate placement of the probe 300 on ECBs with small circuit elements and conductors. One skilled in the art will also understand that when a magnifying lens is selected, the focal length of the lens must be appropriately selected so the camera 200 is maintained sufficiently far enough away from the ECB 400 so that the probe 300 may be maneuvered underneath it.

One skilled in the art will also understand that the stand 600 may be movable. (Details of such a moveable stand 600 are not shown in Fig. 7 to simplify the figure, however such stands exist and one skilled in the art will understand how to select an appropriate one and how to operate it). For example, the camera 200 may be attached to an X-Y platform over the ECB 400. This permits the camera 200 to be moved, as illustrated by arrows in Fig. 7, so that the center of the image 112 on the display device 110 of the oscilloscope 100 is at a desired location on the ECB 400. This may be especially useful if the lens 210 selected for the camera 200 is one that focuses only on a portion of the ECB 400, producing a magnifying effect.

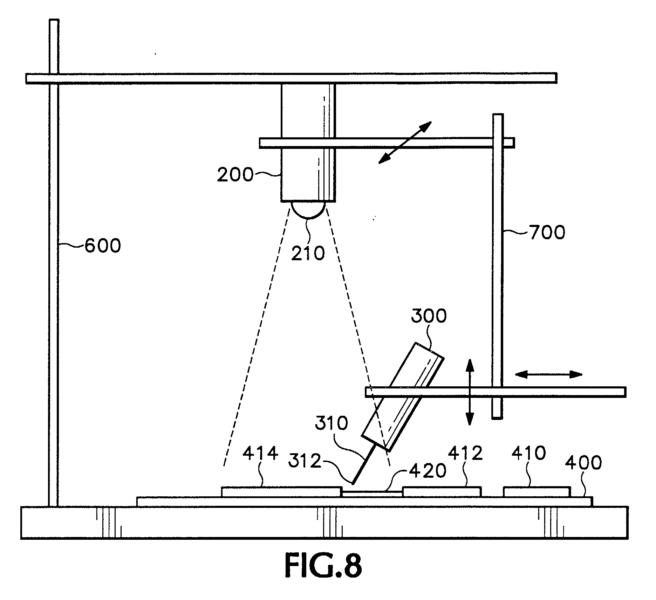

Fig. 8 is a side view of an arrangement in which the probe 300 is moveable relative to the camera 200. In Fig. 8, the ECB 400 is shown from the side, and illustrated as a thin rectangle representing the printed circuit board. Circuit elements 410, 412 and 414 are also illustrated as thin rectangles representing the side view of integrated circuit chips. The connection 420 is illustrated as a thick line representing a trace fabricated on the face of the printed circuit board. One skilled in the art, however, will understand that other arrangements for the ECB 400 are available, and the particular arrangement is not germane to the present invention.

In Fig. 8, a moveable second stand 700 is attached to the camera 200. This frame connects the probe 300 to the camera 200. The probe 300 can be moved relative to the camera 200 by means of this second frame 700, as illustrated by the arrows illustrated next to the frame 700. The first moveable frame 600 is used to position the camera 200 over a desired portion of the ECB 400, that portion being illustrated in Fig. 8 by dashed lines emanating from the lens 210 of the camera 200. The image 112 formed by the camera is displayed on the display device 110 of the oscilloscope 100 (of Fig. 1). The user can then control the positioning of the probe 300 by controlling the second moveable frame 700 so the tip 312 of the connector 310 of the probe 300 moves to the correct connection 420. The waveform 114 of the signal on the connection 420 may then be observed on the display device 110 of the oscilloscope.

Similar to Fig. 7, the lens 210 may be selected so that an appropriate amount of effective magnification of the ECB 400 image is achieved while maintaining the camera 200 at a sufficient distance above the ECB 400 so that the probe 300 may move freely beneath it.

In either Fig. 7, or Fig. 8, the stands 600 and/or 700 may be manually controlled. For example, X-Y positioners are available which are controllable by manipulation of knobs by a user. Alternatively, the stands 600 and/or 700 may be computer controlled. For example, robotic X-Y positioners are available which are controllable in response to electrical signals from, e.g. a computer.

The above description has been written in terms of an oscilloscope. One skilled in the art, however, will understand that any piece of electronic equipment, and in particular any piece of electronic test equipment which includes ports at which probes are attached and which provides power for such probes at those ports, may provide for the functions describe above.

## Claims

1. A test system, comprising:
a test instrument including an input terminal for receiving a test signal, and a power output terminal for supplying electrical power, the test instrument being capable of receiving a video signal at the input terminal and displaying the image represented by that video signal; and
a camera, receiving operating power from the power output terminal of the test instrument, and having an output terminal, generating a video signal, coupled to the input terminal of the test instrument.

2. The test system of claim 1 wherein the camera is attached to a positioner for controlling the position of the camera.

3. The test system of claim 2 wherein the positioner is manually controlled by a user.

4. The test system of claim 2 wherein the positioner is automatically controlled in response to a computer.

5. The test system of claim 1 wherein:
the camera generates a video signal representing an image of a scene at the output terminal; and the test system further includes:
a light source, receiving operating power from the power output terminal of the test instrument, wherein the light from the light source illuminates the scene.

6. The test system of claim 5 wherein the light source is physically attached to the camera and arranged so that the light from the light source illuminates the scene.

7. The test system of claim 6 further comprising a light diffuser arranged between the light source and the scene.

8. The test system of claim 7 wherein the light diffuser surrounds the camera so that light illuminates the scene in a manner tending to lessen shadows cast by the light source.

9. The test system of claim 6 further comprising a second light source, receiving operating power from the power output terminal of the test instrument, physically attached to the camera and arranged so that the light from the second light source illuminates the scene in a manner tending to lessen shadows cast by the first mentioned light source.

10. The test system of claim 9 wherein the first mentioned light source and the second light source are physically attached to substantially opposite sides of the camera.

11. The test system of claim 1 wherein the test instrument is an oscilloscope.

12. The test system of claim 1 further comprising:
a probe, coupleable to a node in an electronic circuit, for receiving a signal from the node and generating a second test signal; wherein:
the test instrument further comprises a second input terminal for receiving the second test signal, the test instrument being capable of displaying information relating to a characteristic of the second test signal.

13. The test system of claim 12 wherein the test instrument is capable of simultaneously displaying the image represented by the video signal, and the characteristic of the second test signal.

14. The test system of claim 12 further comprising a positioner for controlling the position of the camera.

15. The test system of claim 14 further comprising a second positioner, attached to the camera, for controlling the position of the probe relative to the camera.

16. The test system of claim 15 wherein the second positioner is manually controlled by a user.

17. The test system of claim 15 wherein the second positioner is automatically controlled in response to a computer.

18. The test system of claim 12 wherein:
the test instrument is an oscilloscope and displays the waveform of the second test signal.

19. The test system of claim 18 wherein the test instrument is capable of simultaneously displaying the image represented by the video signal, and the waveform of the second test signal.

20. The test system of claim 12 wherein the probe and the camera are physically attached.

21. The test system of claim 20 wherein the probe is physically attached to the camera in a detachable manner.

22. The test system of claim 12 wherein:
the probe includes a tip coupleable to the circuit node;
the camera produces the video signal representing an image of a scene; and
the probe and the camera are physically attached and arranged so that an image of the tip of the probe remains at a fixed location in the image and in focus.

23. The test system of claim 22 wherein the tip of the probe remains fixed substantially at the center of the image.

24. The test system of claim 1 wherein the input terminal is a channel input terminal.

25. The test system of claim 1 wherein the input terminal is a computer data input terminal.

26. The test system of claim 25 wherein the computer data input terminal is a USB terminal.

27. The test system of any preceding claim wherein the test instrument has a port including both the input terminal and the power output terminal.
